# EUROPEAN PATENT SPECIFICATION

(11) **EP 4 294 051 B1**
(45) Date of publication and mention of the grant of the patent: **14.10.2026**
(21) Application number: 22179665.9
(22) Date of filing: 17.06.2022
(51) Int. Cl.: H04R 17/10, H04R 1/28, G10K 15/04, H04R 19/00, H04R 9/06, H04R 23/00

(54) **MEMS DEVICE AND APPARATUS HAVING SUCH A MEMS DEVICE**
MEMS-VORRICHTUNG UND GERÄT MIT EINER SOLCHEN MEMS-VORRICHTUNG
DISPOSITIF MEMS ET APPAREIL DOTÉ D'UN TEL DISPOSITIF MEMS

(43) Date of publication of application: 20.12.2023
(73) Proprietor: Infineon Technologies AG, 85579 Neubiberg (DE)
(72) Inventor: BRETTHAUER, Christian, 81675 München (DE); HAUBOLD, Marco, 01309 Dresden (DE); TIMME, Hans-Joerg, 85521 Ottobrunn (DE); MAYRHOFER, Dominik, 8010 Graz (DE)
(74) Representative: Infineon Patent Department

(56) References cited:
- WO-A1-2015/119626
- WO-A1-2019/004933
- US-A1- 2017 064 450
- US-A1- 2020 087 138

## Description

The present disclosure relates to a MEMS device and to an apparatus having such a MEMS device. The present disclosure in particular relates to a MEMS structure with horizontal shutter and optional driving membrane for micro-speaker, valve and pumping applications.

MEMS structures may be used for generating a pressure wave and/or a flow in a fluid, e.g., a gas. Such a MEMS device may comprise a moveable part interacting with the fluid, e.g., a membrane. Examples of such MEMS devices are pumps, loudspeakers, or microphones.

A MEMS device may comprise semiconductor materials, for example, on a basis of silicon, wherein electrical current may flow based on conductive materials such as metal materials and/or doping of a semiconductor material.

WO 2015/119626 A1 relates to methods and systems related to a MEMS-based audio speaker system that includes a first movable element, formed from a first layer of a semiconductor substrate, and a second movable element, formed from a second layer of the semiconductor substrate that is a different layer than the first layer of the semiconductor substrate.

US 2017/0064450 A1 relates to devices related to digital MEMS loudspeakers. Such devices may include an air pressure source, MEMS valves coupled to the air pressure source, and an audio modulator coupled to the MEMS valve to receive an audio signal and to control the MEMS valves via a modulation signal to provide an acoustic output.

There is a need to enhance MEMS devices.

An object underlying the present embodiments is, thus, to enhance MEMS devices.

According to an embodiment, a MEMS device comprises a set of features according to claim 1.

According to an embodiment, an apparatus comprises such a MEMS device and is a loudspeaker.

Preferred embodiments in accordance with the present disclosure are described herein whilst making reference to the accompanying drawings, in which
- Fig. 1: shows a schematic side view of a MEMS device according to an embodiment;
- Fig. 2: shows a schematic side view of a part of a MEMS device according to an embodiment, having a control circuitry;
- Fig. 3a: shows a schematic side view of a part of the MEMS device of Fig. 2 in a first position of a shutter structure;
- Fig. 3b: shows a schematic side view of a part of the MEMS device of Fig. 3a in a second position of the shutter structure;
- Fig. 4a: shows a schematic side view of a MEMS device according to an embodiment having an interface for a connection to exchange a signal with an external control circuitry and in the first position of the shutter structure;
- Fig. 4b: shows the MEMS device of Fig. 4a in the second position of the shutter structure;
- Fig. 5a: shows schematic views of a MEMS device according to an embodiment, and in the first position of the shutter structure for illustrating possible dimensions of the MEMS device;
- Fig. 5b: shows schematic views of the MEMS device of Fig. 5a in the second position of the shutter structure for illustrating possible dimensions of the MEMS device;
- Fig. 6a: shows a schematic top view of a part of a MEMS device according to an embodiment, to illustrate details of a shutter structure;
- Fig. 6b: shows as schematic top view of a layer of a perforated structure according to an embodiment;
- Fig. 7: shows a schematic perspective view of a shutter element part of a MEMS device according to an embodiment, having a plurality of valve structures;
- Fig. 8: shows a schematic diagram for illustrating the superposition of single sound pulses generated to reconstruct the analog audio signal after the ultrasonic demodulation according to an embodiment;
- Fig. 9: shows a schematic plot illustrating a possible sound pressure characteristic over time generated with different shutter configurations according to an embodiment;
- Fig. 10: shows a schematic top view of a part of a MEMS device according to an embodiment, having a plurality of valve structures; and
- Fig. 11: shows a schematic block diagram of an apparatus according to an embodiment.

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present disclosure. In other instances, well known structures and devices are shown in block diagram form rather than in detail in order to avoid obscuring embodiments of the present disclosure.

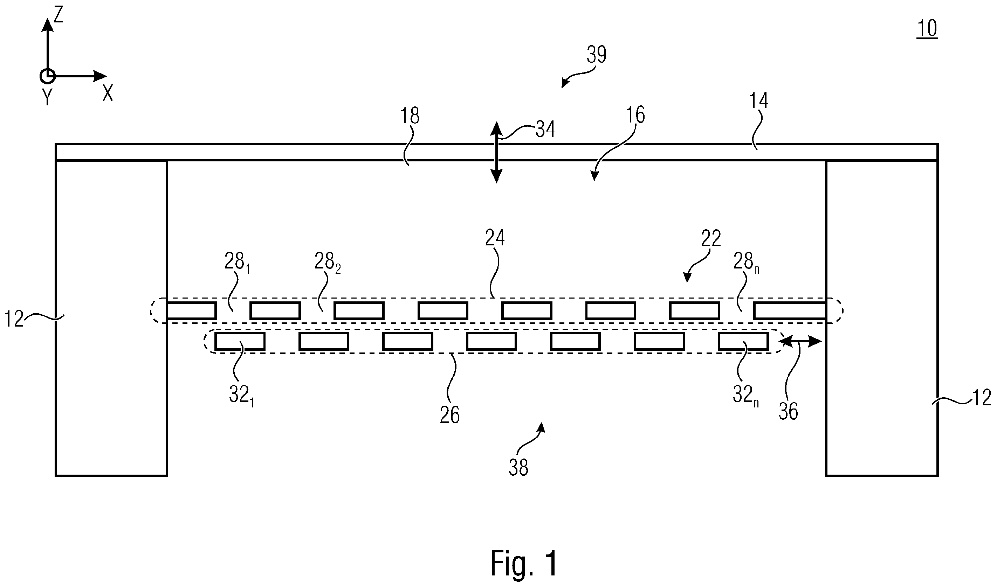

Fig. 1 shows a schematic side view of a MEMS device 10 according to an embodiment. The MEMS device comprises a substrate 12, e.g., comprising a semiconductor material such as silicon or silicon based materials. Alternatively, or in addition, other types of semiconductor materials may form at least a part of substrate 12, e.g., gallium arsenide or the like.

The MEMS device 10 comprises a membrane structure 14 being mechanically connected to the substrate 12. The membrane structure 14 is directly or indirectly hinged or connected to the substrate 12. The membrane structure 14 is provided parallel to a substrate plane, e.g., it may be arranged in an unactuated state essentially parallel to a substrate plane x/y, i.e., in-plane. The membrane structure 14 is deflectable out-of-plane, e.g., based on an actuation signal and/or based on a pressure of a fluid 16 being present in a cavity 18 of the MEMS device 10, of the substrate 12, respectively. The membrane structure 14 may be implemented as a planar structure having, for example, a rectangular, round or essentially square shape or a structure inbetween e.g. oval or alveolate. The membrane structure 14, may also be formed as a cantilever beam.

By way of non-limiting example only, a MEMS device may be formed from at least one wafer or other basis structure. Such a wafer may be considered as a plate-like structure that has a comparatively low thickness when compared to longitudinal extensions. Without limiting such considerations to a specific coordinate system or realization of a structure, the longitudinal directions may be considered as defining an in-plane direction of a MEMS device. Such directions are shown in Fig. 1 as x/y-directions. A thickness direction z may be considered as a thickness direction perpendicular to the in-plane directions x/y. The membrane structure 14 deflects out-of-plane and, thus, along a positive and/or negative z-direction.

The membrane structure 14 is configured for deflecting along the z-direction with a frequency in ultra-sonic frequency range to cause a motion of the fluid 16. The motion comprises a flow of the fluid 16 through a valve or shutter structure 22 and/or may relate to a pressure or change thereof generated in the cavity 18. For example, the membrane structure 14 is configured for and controlled to deflect out-of-plane with an ultrasonic frequency. That is, the deflection of the membrane structure 14 is controlled in a frequency range inaudible for a human. However, by use of a MEMS membrane structure that possibly has a comparatively small size and thus moves a small amount of fluid, a high rate of moving such small amounts results in considerable fluid set under pressure, e.g., in a front volume. To avoid moving the fluid 16 back and forth with the membrane structure, the controllable valve structure is used to allow, based on a control signal for the valve structure 22, a fluid pulse or fluid motion away from the membrane structure 14 through the valve structure 22 towards a front volume 38. In addition, the MEMS device 10 may provide for a back volume 39 on a different side of the membrane structure 12. The whole MEMS device 10 may thus offer a front and a back port for fluid and/or sound.

Based on closing the valve structure 22 during a time the membrane structure 14 moves away from the valve structure, e.g., along +z, and again opening the valve structure 22 when the membrane structure 14 moves towards the valve structure 22 again, e.g., along -z, fluid pulses or fluid 16 may be accumulated in the front volume 38.

The membrane structure moves or vibrates with an ultrasonic frequency, e.g. a frequency of at least 20 kHz, at least 30 kHz or even more, i.e., with an ultrasonic frequency range. For example, the membrane may vibrate with a frequency of at least 50 kHz, at least 70 kHz or at least 90 kHz, e.g., approximately or equal to 96 kHz, wherein some structures may also allow for a frequency of at least 200 kHz, 300 kHz or up to 500 kHz or more to cover a range between at least 50 kHz and at most 500 kHz. Such an ultrasonic frequency range may be demodulated to an audible frequency range, i.e., an audio frequency range, e.g., below 20 kHz.

The valve structure 22 and the membrane structure 14 together sandwich the cavity 18, wherein based on a control of valve structure 22 different fluidic resistances for the fluid may be provided. According to one example, the valve 22 is switched between an open state in which the valve structure 22 basically provides for a low, negligible or no fluidic resistance and a second state, in which the valve structure 22 is considered in a closed state in which the valve structure provides for a comparatively higher fluidic resistance for the fluid 16. For example, in the closed state, there is no or only negligible flow from the fluid 16 through the valve structure 22.

The valve structure 22 comprises a planar perforated structure 24 and a shutter structure 26 moveable with respect to the perforated structure 24. In one example, the perforated structure 24 may be an immoveable structure, e.g., a statue or the like, for example, immovably connected to the substrate 12. However, according to other examples, both structures, the perforated structure 24 and the shutter structure 26 may be moveably arranged and may move with regard to each other.

The perforated structure 24 may comprise a plurality of openings 28₁ to 28ₙ that allow the fluid 16 to pass through. According to an embodiment, the shutter structure 26 may comprise structural sections 32₁ to 32ₙ that are adapted for an opposing position with regard to the openings 28₁ to 28ₙ in the second position to provide for the second fluidic resistance.

By use of the valve structure 22, the ultrasonic waves in the cavity 18 are transferred to other frequency ranges, e.g., an audible or audio frequency range.

Whilst using a membrane being deflectable along a direction of movement 34 being possibly parallel to the z-direction, which may allow for a large amount of fluid to be moved, a direction of movement 36 of the valve structure 22, e.g., the shutter structure 26, may allow for a low thickness of the MEMS device 10, which comprises a control unit and/or an interface for a connection with an external control unit. Such a control unit may comprise a control circuitry configured for controlling a deflection of the membrane structure 14 to deflect with a first ultrasonic frequency and for controlling the valve structure 22, e.g., an actuator structure connected to the shutter structure 26 to change between the first position and the second position with a same or a different second ultrasonic frequency to generate a sound pressure level in a front volume 38 of the MEMS device 10 in an audio frequency range, the sound pressure level in the audio frequency range being generated from the ultrasonic frequency of the membrane structure 14, i.e., by use of the valve structure 22, the membrane sound may be modulated or demodulated so as to obtain an audio signal. For example, such a demodulation/modulation may comprise an advanced digital sound reconstruction, ADSR, or other ultrasonic demodulation, UD, concepts, e.g., a single-sideband demodulation or dual-sideband demodulation techniques.

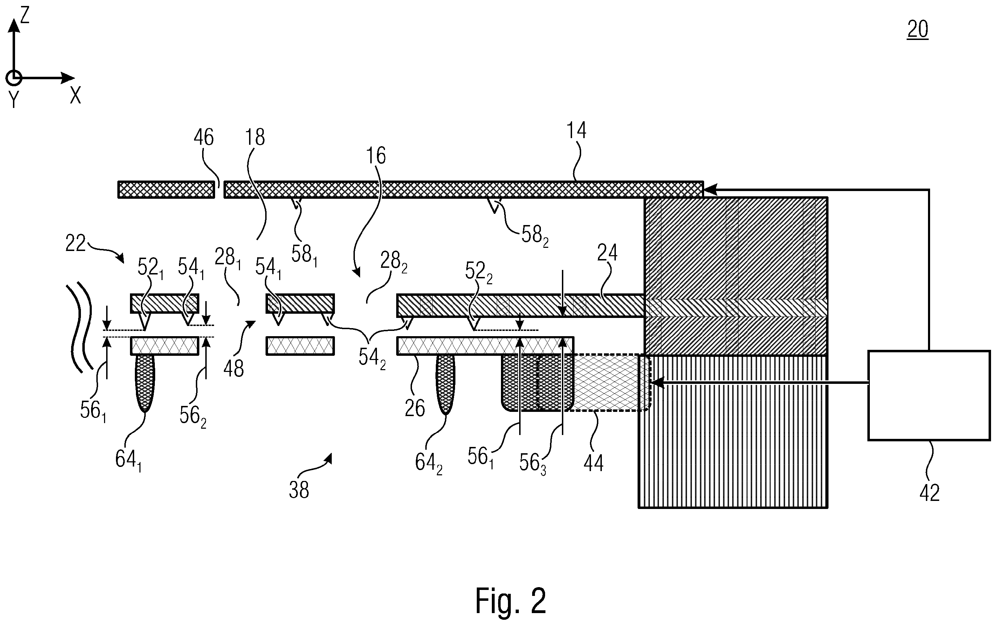

Fig. 2 shows a schematic side view of a part of a MEMS device 20 according to an embodiment, wherein the details provided may be applied, without limitation, to other MEMS devices described herein.

MEMS device 20 comprises a control circuitry 42, e.g., comprising a processing unit, a microcontroller, an application-specific integrated circuit, ASIC, a field programmable gate array, FPGA, or other suitable circuitry, configured for controlling a deflection of the membrane structure 14. The control circuitry 42 is further configured for controlling an actuator structure 44 connected to the shutter structure 26 to change between the first position shown in Fig. 2 and the second position indicated in Fig. 1. The change between the first position and the second position may be obtained with a same or a different ultrasonic frequency and both controls commonly may allow to generate a sound pressure level in the front volume 38, which is in the audio frequency range, i.e., in a frequency range of at least 10 Hz and at most 20 kHz. A MEMS device in accordance with embodiments described herein may have good properties especially in a low frequency audio range, e.g., in a range of at most 1 kHz, at most 800 Hz or at most 500 Hz and even far below. The actuator structure may comprise, for example, a piezoelectric actuator, an electrodynamic actuator or other types of actuating structures. For example, the actuator structure 44 may comprise an electrodynamic comb-structure, a magnetic drive, a piezoelectric drive and/or a thermal drive. The actuator structure 44 may comprise more than a single actuator, e.g., actuator structures 44₁ and 44₂ so as to generate active forces along positive and negative directions of movement 36. This may allow for a highly controllable generation of sound when compared to relying on restoring forces of springs only.

By driving the membrane structure 14 and the valve structure 22 with a same or a different ultrasonic frequency, a modulation of the sound generated by the membrane structure 14 is obtained.

A MEMS device in accordance with an embodiment may comprise a membrane structure 14 that comprises a plurality of ventilation holes 46 configured for a passage of the fluid 16 into the cavity 18 whilst preventing an acoustic short circuit. The ventilation holes 46 may have a synergetic effect and may, for example, first serve as holes that are now to etch a sacrificial layer to generate at least a part of the cavity 18. The ventilation holes 46 may comprise a comparatively low size along the x- and/or y-direction to prevent for an acoustic short circuit. That is, the ventilation holes 46 may have a high fluidic resistance which increases with ~1/d⁴ wherein d refers to a .hole diameter.

That is, the ventilation holes 46 may allow to remove the sacrificial layer without generating an acoustic short circuit. Such an acoustic short circuit may be understood as an effect that the membrane structure 14 deflects along a direction, but only provides for insufficient pressure or movement of fluid 16 as the fluidic resistance of the ventilation holes 46 is too low, such that the fluid 16 travels through such holes instead of being moved by the membrane structure. A size of the ventilation holes 46 may be tuned to achieve a fluidic resistance for the fluid 16 that is high enough to allow efficient flow generation through the valve structure 22 and to be low enough to allow for ventilation of the cavity 18 through the membrane structure 14 when the valve structure 22 is in a closed state, i.e., the shutter structure 26 is in the second position. A diameter of such a ventilation hole may be, for example, in a range of at least 0.5 µm and at most 5 µm, at least 0.7 µm and at most 4 µm or of at least 1 µm and at most 3 µm.

Alternatively or in addition to the ventilation holes 46, the MEMS structure 20 and/or the MEMS structure 10 may comprise a bump structure 48 which may have a set of bumps, a continuous or discontinuous ring-like structure of at least one bump or the like that is arranged between the perforated structure 24 and the shutter structure 26. During manufacturing of the MEMS device 20, the bump structure 48 may, for example, be formed as a part of the perforated structure 24 and/or as a part of the shutter structure 26.

In a closed state of the valve structure 22, the bump structure 48 may prevent a fluid through the valve structure 22 based on a mechanical contact between the perforated structure 24 and the shutter structure 26 via the bump structure 48. That is, although showing a remaining distance between the bump structure 48 and the shutter structure 26, the MEMS device 20 of Fig. 2 may provide for a mechanical contact of the shutter structure 26 with the bump structure 48. The bump structure 48 may synergistically allow for providing a protection against stiction of the shutter structure 26 to the perforated structure 24 and to provide for a sort of a seal, e.g., a ring, around the perforation or opening 28 to pinch-off the flow of fluid 16 in case the shutter structure 26 is in the second position.

According to an embodiment, the bump structure 48 comprises bump elements with different properties and/or for different purposes. For example, the bump elements 52₁ and 52₂ may comprise a comparatively long extension along the z-direction, i.e., they may be comparatively long. The bump elements 52₁ and 52₂ may be configured for providing a point-like contacting surface with the shutter structure 26 so as to provide for anti-stiction function. By having the bump elements 52₁, 52₂ with a point-like surface or at least a small contact area, good anti-stiction properties may be obtained. The bump elements 52₁ and/or 52₂ as an alternative or in addition allow to have a low amount of disturbing noise in the demodulated audio signal as a surface area that generates friction and thereby possibly noise when changing the position of the shutter structure 26 is small.

According to an embodiment, a MEMS device according to the present disclosure may provide for anti-stiction bumps 52₁/52₂ between the perforated structure 24 and the shutter structure 26 and may comprise a sealing structure 54₁/54₂ between the perforated structure 24 and the shutter structure 26. A remaining gap 56₂ in an area of the sealing structure 54₁/54₂ may be larger when compared to a gap 56₁ in an area of the anti-stiction bumps 52₁/52₂.

The bump structure 48 may alternatively or in addition comprise a continuous or segmented bump element 54₁/54₂ that may form at least a part of a ring through a respective opening 28₁, 28₂ respectively. When compared to the bump elements 52₁, 52₂, a length along the z-direction of bump elements 54₁, 54₂ may be smaller. A reduced length or height of bumps 54₁, 54₂ when compared to bump elements may result, at least during regular operation, in that the bump elements 54₁, 54₂ do not provide for a mechanical contact but reduce or at least partly obstruct a slit along the z-direction, the slit being between the perforated structure 24 and the shutter structure 26. That is, elements 54, and 54₂ are not necessarily bumps but can also for a different type of protrusion or elevation.

To have different heights of bump elements used for different purposes may allow to maintain good anti-stiction properties by use of bump elements 52₁, 52₂ even in case of having a comparatively large surface provided by sealing bumps or sealing elevations 54 as they do not necessarily contribute to the anti-stiction functionality. A gap 56₁ remaining between bump elements 52₁ and shutter structure 26 may be comparatively low, down to zero in a case where the bumps contact or abut the opposing structure. A gap 56₂ between the bump element 54₁ or 54₂ on the one hand and shutter structure 26 on the other hand may, at a same time, be non-zero which may be interpreted as a remaining pinching slit even if the valve structure 22 is in a closed position. Such a gap may have a size, for example, of at least 100 nm and at most 1000 nm, of at least 200 nm and at most 700 nm or of at least 300 nm and at most 500 nm. A gap 56₃ between the shutter structure 26 and the perforated structure 24 may, at a same time, be in a range of at least 600 nm and at most 1500 nm. That is, bump elements 54, and 54₂ may provide to tighten or seal the cavity 18 even if a small gap 56₂ remains.

Bump structure 48 does not prevent bump elements 58₁ and/or 58₂ to be arranged between the membrane structure 14 and the valve structure 22. It has to be noted that the perforated structure 24 or the shutter structure 26 may be arranged closer to the membrane structure 14 when compared to the other structure.

Alternatively or in addition to the bump structure 48 and/or the ventilation holes 46, the shutter structure 26 may comprise a mechanical stiffening 64₁, 64₂ configured for suppressing an out-of-plane deflection of the shutter structure 26. For example, the mechanical stiffening 64₁, 64₂ may comprise a locally increased thickness of the shutter structure 26, e.g., a beam-like structure or a bar-like structure. Alternatively or in addition, an additional layer or structure may be arranged to locally stiffen the shutter structure to increase weight of the moved structure only as much as desired. Alternatively or in addition to the stiffening of the perforated structure, wherein the shutter structure may comprise a mechanical stiffening, the mechanical stiffening configured for suppressing an out-of-plane deflection of the shutter structure.

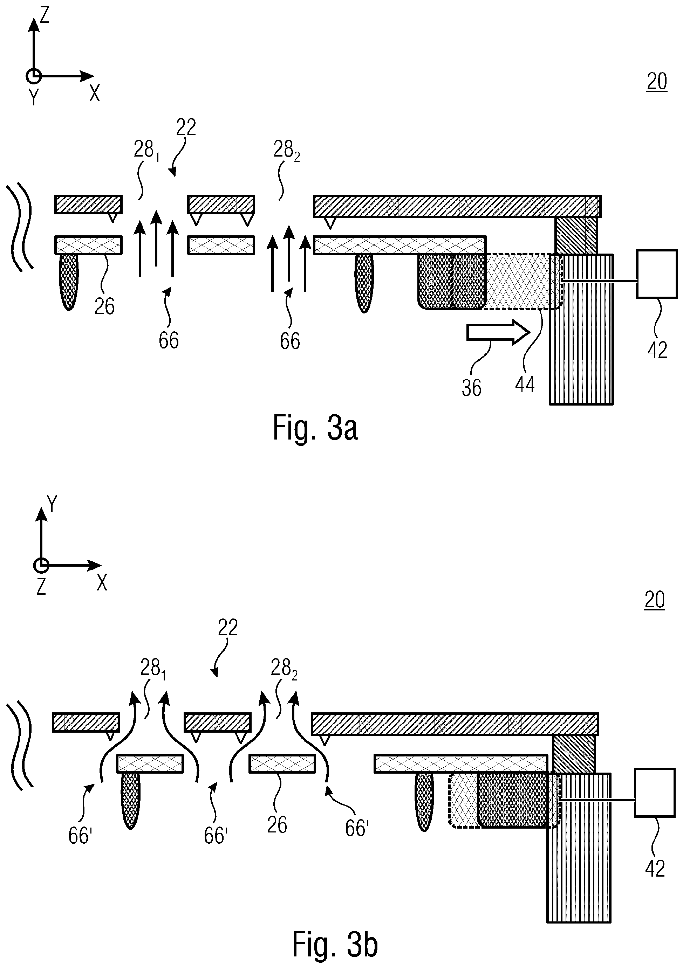

Fig. 3a shows a schematic side view of a part of the MEMS device 20 in which the valve structure 22, the shutter structure 26 respectively is in the first position. In the first position, a low resistance for a fluid or a flow thereof is provided by valve structure 22 as indicated by arrows 66. The control circuitry 42 may control the actuator structure 44 to move the shutter structure 26 along the direction of movement 36 to arrive at the second position indicated which is shown in the schematic side view of the part of the MEMS device 20 in Fig. 3b.

Alternatively or in addition, the control circuitry 42 may control the actuator structure 44 to actively move the shutter structure from the second position into the first position. A rest position of the shutter structure 26 may at least partially be based on hinges or spring structures and the actuator structure 44 may be controlled to move the shutter structure away from such a rest position. Arrows 66' in Fig. 3b indicate a high resistance provided by valve structure 22 arriving at a low amount of fluid travelling through openings 28₁ and 28₂.

According to an embodiment, the shutter structure 26 may comprise a lattice structure comprising at least one bar that, when being projected into a common plane parallel to the substrate plane x/y, overlaps with an opening 28 of a perforation of the perforated structure 26 in the second position and reveals at least a part of the opening in the first position when being projected into the common plane as shown, for example, in Fig. 3a.

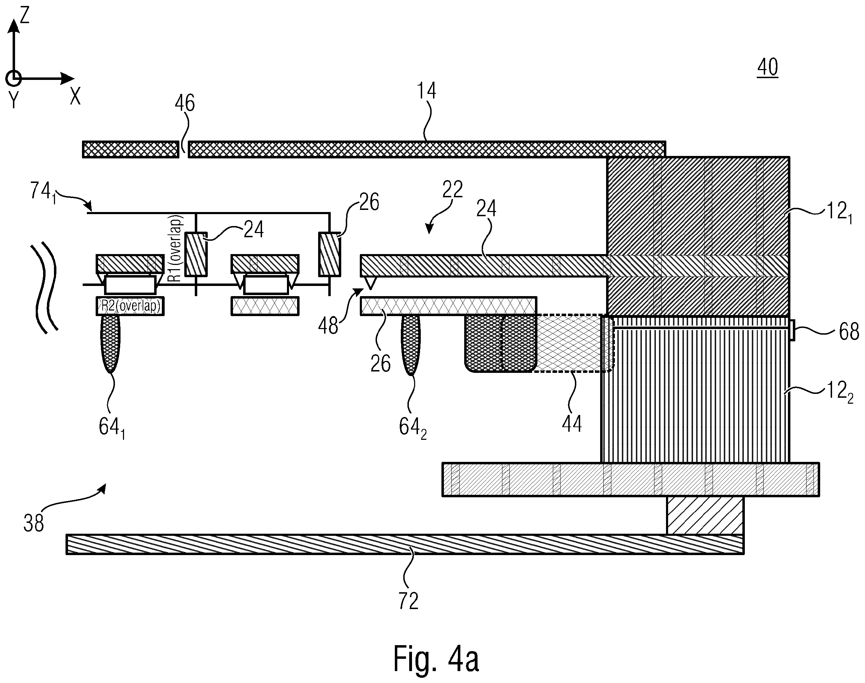

Fig. 4a shows a schematic side view of a MEMS device 40 according to an embodiment. The MEMS device 40 comprises, for example, an interface 68 to allow a connection to exchange a signal with an external control circuitry, whilst the control circuitry 42 of a MEMS device 20 may be an internal circuitry of the MEMs device.

Alternatively or in addition, the MEMS device 40 may comprise a protective structure 72 which may also be arranged at MEMS device 10 and/or 20. The protective structure 72 may be transparent for a sound pressure level, e.g., in the audio range, of the fluid whilst being configured for mechanically protecting the valve structure 22. The protective structure 72 may sandwich the valve structure 22 together with the membrane structure, i.e., the valve structure 22 may be arranged between the membrane structure 14 and the protective structure 72. The protective structure 72 may comprise, for example, a plastic material, a semiconductor material and/or a glass material. For example, a plastic material, i.e., a membrane comprising the plastic material, may be well-suited to block ultrasonic sound whilst being transparent for audible frequencies. A glass structure forming at least a part of the protective structure 72 may comprise a mesh-like structure, may provide for a high mechanical robustness, and may comprise small openings that may act as ventilation holes. Alternatively or in addition, a structured glass may be provided, e.g., as a part of a glass package, may be provided with a kind of perforation to block particles on the one hand side but also to attenuate the ultrasound signal(s) on the other side.

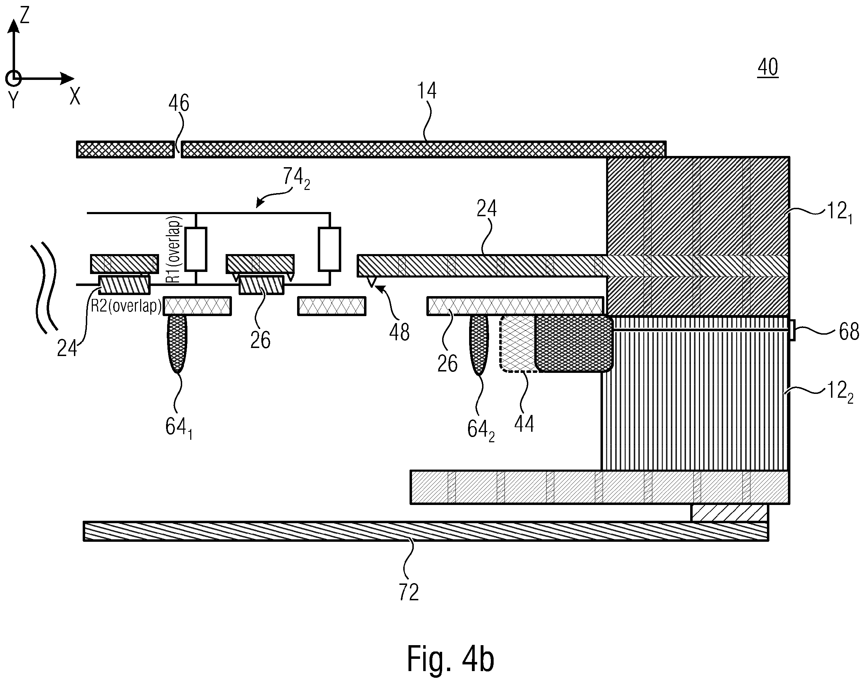

Fig. 4b shows a schematic side view of the MEMS device 40 of Fig. 4a where the shutter structure 26 is in the second position. As shown in a schematic equivalent circuit diagram 74 in Figs. 4a and 4b, the fluidic resistance of Fig. 4a represented therein may be understood as parallel connection of resistors whilst the second position shown in Fig. 4b may result in a serial-connection. In an electronic analogy, the parallel connection may result in a lower effective resistance when compared to the serial-connection.

The external or internal control circuitry may be configured for controlling the actuator structure 44 to move the shutter structure 26 into the first position or into the second position at an instance of time based on a deflection state of the membrane structure 14 at that instance of time. That is, the control circuitry may temporally align a control of the membrane structure 14 and of the shutter structure 26. For example, the control circuitry may control the actuator structure 44 so as to provide for the first position of the valve structure at a time when the membrane provides for pressure in the cavity or may provide for a closed state of the valve structure 22 at this time. For example, the control circuitry 42 may be configured for controlling the actuator structure 44 and the membrane structure 14 for aggregating a fluidic pressure of the fluid motion generated by the membrane structure 14 to have an aggregated pressure in the front volume by use of the valve structure. In other words, the membrane structure 14 may aggregate pressure, e.g., by pumping a contribution in the front volume whilst having the valve structure 22 in an open state and the valve structure 22 may be controlled into a closed state when the membrane 14 moves back again. According to other types of ultrasonic demodulation, e.g., ADSR, the membrane structure on the one hand and the shutter position on the other hand may also be unsynchronized.

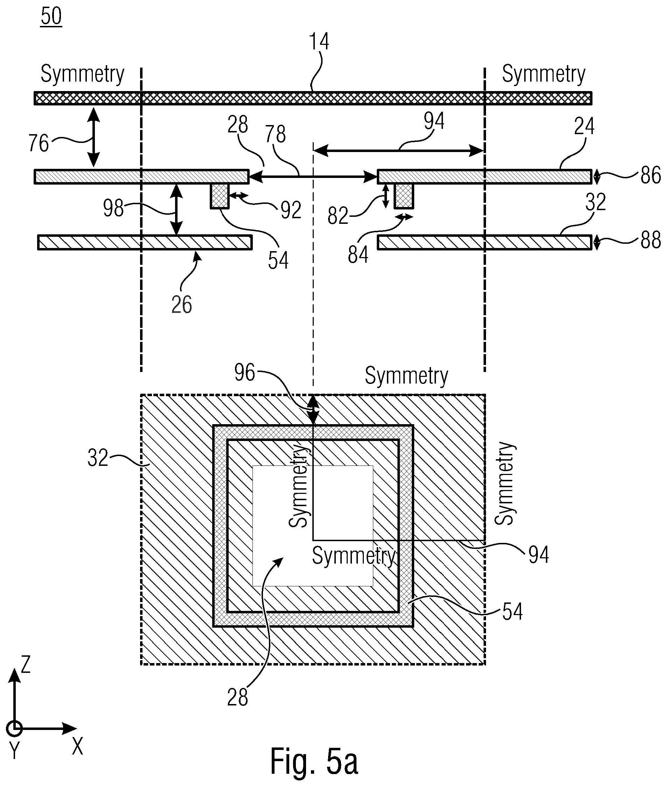

Fig. 5a shows schematic views of a MEMS device 50 according to an embodiment, wherein the details provided may be applied, without limitation, to other MEMS devices described herein.

A gap 76 between the membrane structure 14 and the valve structure 22, e.g., the perforated structure 24 may have any suitable value which may be designed in accordance with a maximum deflection of the membrane structure 14 which may depend, for example, on the driving voltage and/or a diameter of the membrane structure 14. A size 78, e.g., a diameter, of a hole 28 of the perforated structure 28 may be, for example, in a range of at least 3 µm and at most 5 µm.

An extension 82 of bump elements 54 along the z-direction may be, for example, in a range of at least 100 nm and at most 500 nm, of at least 150 nm and at most 400 nm or at least 200 nm and at most 300 nm or other suitable values to arrive at the gaps described in connection with Fig. 2.

An extension 84 perpendicular to extension 82 may be, for example, in a range of at least 100 nm and at most 700 nm, of at least 150 nm and at most 600 nm or of at least 300 nm and at most 500 nm.

A thickness 86 of, e.g., the perforated structure 24 may comprise, for example, at least 100 nm and at most 2 µm, at least 200 nm and at most 1 µm or at 300 nm and at most 600 nm.

A thickness 88 of the shutter structure 26 may be in a same range and may have a same or a different value.

An overlap 92 starting from the bump element 54 towards the opening 28 of the perforated structure 24 may have a size of, for example, at least 100 nm and at most 800 nm, at least 150 nm and at most 700 nm or of at least 200 nm and at most 500 nm. An extension 94 may comprise half of extension 78, the overlap extension 92 and a width 84 and may form a basis for a symmetry used for generating the perforated structure 24 and/or the shutter structure 26.

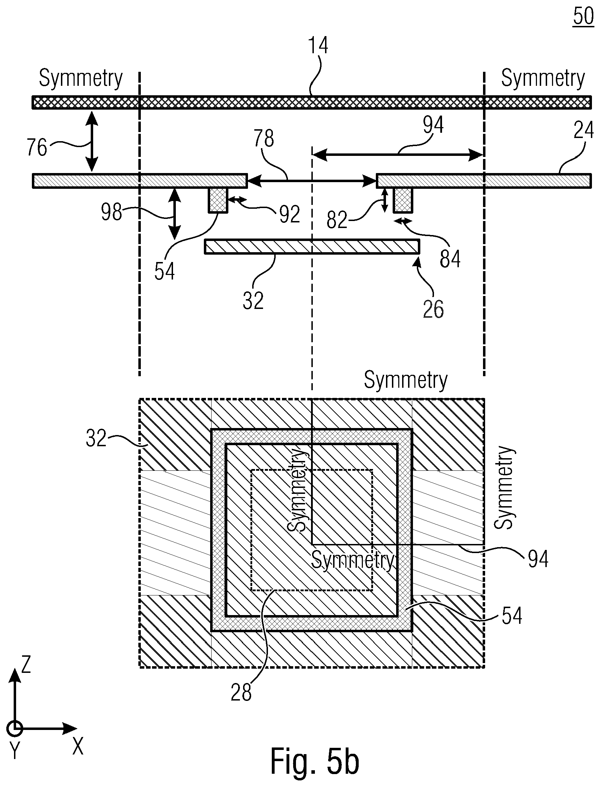

An additional extension y₀ shown in the top view of Fig. 5a and 5b may be in a range of, for example, at least 1 µm and at most 10 µm, at least 2 µm and at most 7 µm, or of at least 3 µm and at most 5 µm.

A gap 98 between the perforated structure 24 and the shutter structure 26 may be in a range, for example, of at least 100 nm and at most 800 nm, of at least 150 nm and at most 600 nm or of at least 300 nm and at most 500 nm.

In the schematic illustration of Fig. 5b, the structural section 32 of shutter structure 26 is moved so as to overlap the opening 28 and optionally the bump elements 54 so as to provide for the closed state of valve structure 22.

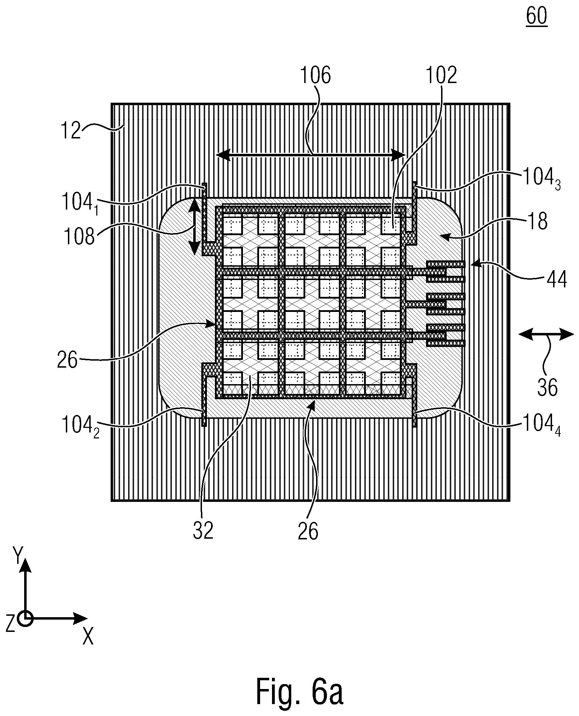

Fig. 6a shows a schematic top view of a part of a MEMS device 60 according to an embodiment, wherein the details provided may be applied, without limitation, to other MEMS devices described herein. In particular, a layer of the shutter structure 26 is shown. A two-dimensional layout of the structural section 32 of the shutter structure 26 is shown, leading also to a two-dimensional arrangement of openings 102 that may overlap openings 28 of a perforated structure in the first state. One or more spring structures 104₁ to 104₄ in Fig 6a may form a part of the MEMS device 60. The at least one spring structure 104₁ to 104₄ may be formed, for example, as a ridge or other type of spring that may allow to move the shutter structure 26 along the x- and/or y-direction whilst preventing such a movement, for example, along a z-direction. A geometry of spring structures 104₁ to 104₄ may also restrict a movement of the shutter structure 26 along one of the directions x and y whilst facilitating the movement along the other direction, e.g., the direction x along which the actuator structure 44 may generate a force so as to deflect the shutter structure 26. That is, the spring structure may, at least in the combination of spring elements, comprise an out-of-plane mechanical stiffness along the z direction being larger when compared to an in-plane mechanical stiffness along the direction of movement 36.

The spring structures 104₁ to 104₄ may elastically hinge the shutter structure 26, e.g., at the substrate 12 and/or at the stator or perforated structure 24 in a rest position, the actuator structure 44 configured for deflecting the shutter structure 26 in-plane along a direction of movement, e.g., x, and out of the rest position.

An extension 106 of the shutter structure 26 along x and/or y may be, for example, in a range of at least 500 µm and some millimeter, e.g., around 1 mm. A length 108 of the spring structures 104₁ to 104₄ may be in a range of at least 50 µm and at most 300 µm, at least 70 µm and at most 200 µm or at least 90 µm and at most 150 µm, e.g., 100 µm. Those dimensions are example values only as well as the number of spring structures 104. For example, one, two, three or more than four spring structures 104 may be arranged, e.g., six, eight, nine or more. Alternatively or in addition, the structural extensions may comprise any other value.

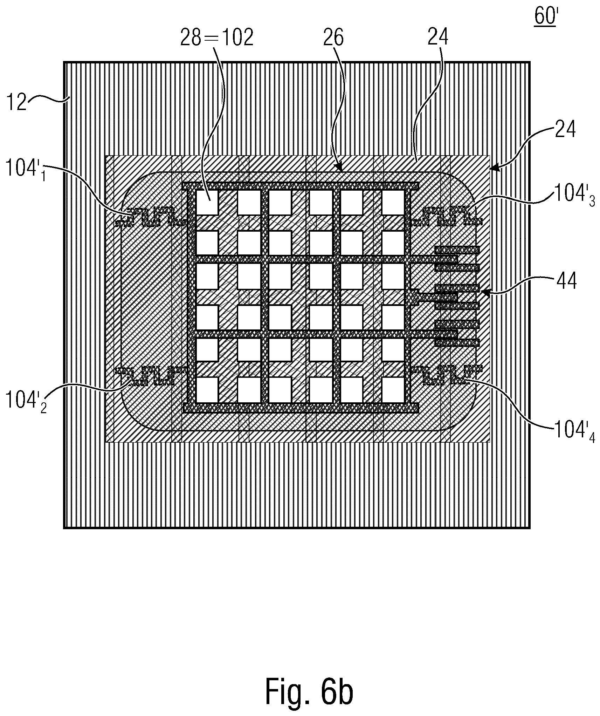

Fig. 6b shows as schematic top view of a layer of the perforated structure 24 according to an embodiment. When compared to the MEMS structure 60, spring elements 104'₁ to 104'₄ may be configured for compression and elongation whilst spring structures 104₁ to 104₄ may be configured for bending.

As may be seen from Fig. 6b, openings 28 and 102 may overlap in the illustrated first position of the shutter structure 26.

Based on spring structures 104, 104' and/or a combination thereof which forms also an embodiment, the shutter structure 26 and the at least one spring structure may form at least a part of a resonator having a resonance frequency, said resonance frequency being in the ultrasonic frequency range of, for example, at least 20 kHz, at least 30 kHz, at least 40 kHz or more.

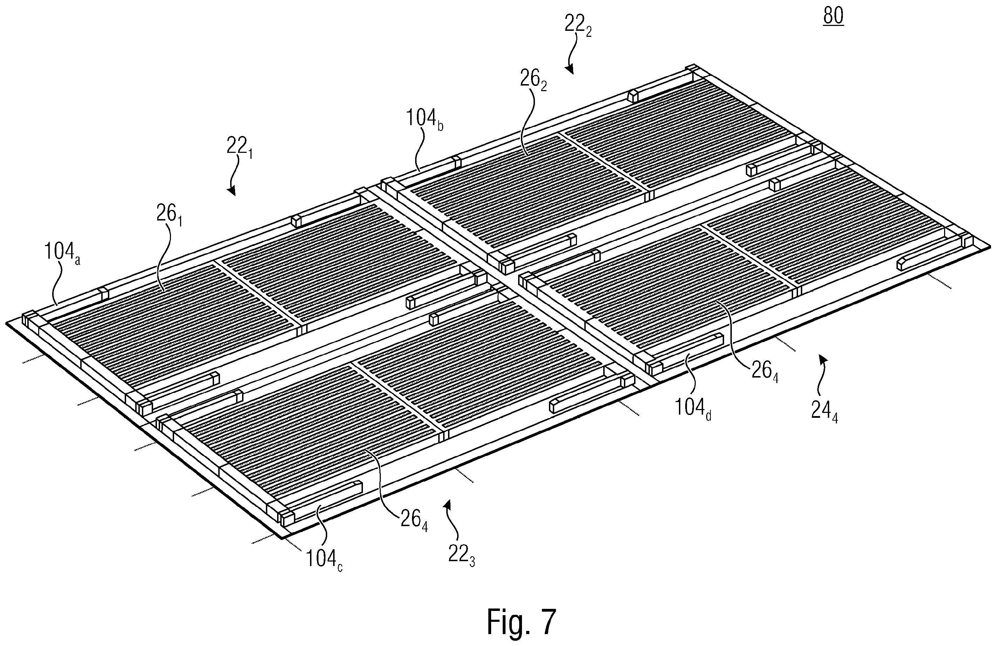

Fig. 7 shows a schematic perspective view of a part of a MEMS device 80 according to an embodiment, wherein the details provided may be applied, without limitation, to other MEMS devices described herein. Therein, for example, more than one, e.g., four valve structures 22₁ to 22₄ may be arranged in a one-dimensional or two-dimensional array. Fig. 7 shows the shutter structures 26₁ to 26₄ of the respective valve structures 22₁ to 22₄.

As an example, each shutter structure 26₁ to 26₄ may comprise a dimension of approximately 100 µm x 200 µm in the x/y-plane, wherein other dimensions are possible and/or shutter structures 26₁ to 26₄ may be formed of different sizes.

Fig. 7 illustrates an embodiment where a plurality of valve structures 22₁ to 22₄ sandwich the cavity together with a common membrane structure, wherein a control circuitry being part of or connected to the MEMS structure 80 may be configured for controlling the membrane structure 14 and for individually controlling a position of the plurality of valve structures 22₁ to 22₄ for providing different spectra of the fluidic motion from the cavity with the plurality of valve structures. An individual control may comprise an individual control signal provided by the control circuitry and/or may comprise different resonance frequencies of a respective resonator structure which may comprise different stiffnesses of spring structures 104a to 104d that may hinge the respective shutter structure 26₁ to 26₄ and/or different masses contributing to the resonator structure.

This may result in different frequencies of movement for the resonator structures 26₁ to 26₄ to a respective control signal having the intended frequency or being of a broadband characteristic so as to excite resonant movement of one, more or all of the resonator structures.

This may allow to generate more than a single tone or frequency component with the MEMS structure at a time.

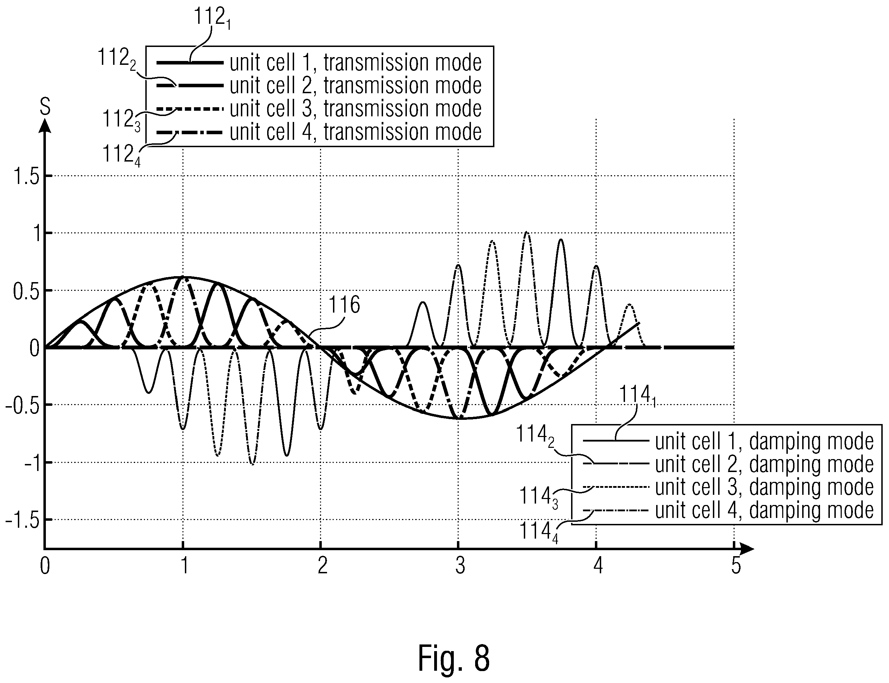

Fig. 8 shows a schematic diagram for illustrating such a concept. There is plotted a time axis at the abscissa and an example normalized sound pressure level S at the ordinate. Plots 112₁ to 112₄ schematically show pressure levels generated with a respective unit cell, e.g., by use of one of shutter structures 26₁ to 26₄ of MEMS device 80. Based on different pressure pulses, an overall sound 116 may be formed based on a superposition of partial sound pressure contributions 112₁ to 112₄. Plots 114 show, for a respective same cell the contribution in a damping mode, i.e., during a time where the membrane moves backward but where the valve structure is closed, wherein, as described above, a synchronization is not required. In other words, the vibration of the membrane structure on the one hand and the vibration related to the operation of the valve structures on the other hand may remain unsynchronized. According to an embodiment, the valve columns itself may have a constant phase shift of, e.g., 90°, to each other

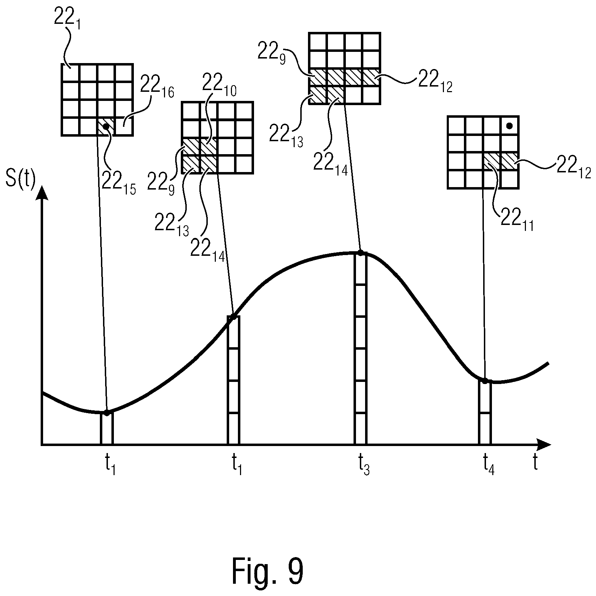

Fig. 9 shows a schematic plot illustrating a possible sound pressure S over time t for a MEMS device that comprises, for example, 16 valve structures 22₁ to 22₁₆ arranged in an example quadratic two-dimensional array, wherein any other number of valve structures and/or any other layout is possible. Fig. 9 shows that during different times, e.g., time instances t₁, t₂, t₃ and/or t₄ a different number of valve structures 22₁ to 22₁₆ may participate in sound generation and/or that different valve structures, for example, to arrive at different spectra, volume components or contributions to an overall sound, may be used to generate sound. During time instance t₁, a single valve structure 22₁₅ is active in the described example. During time instance t₂, a number of four valve structures 22₉, 22₁₀, 22₁₃ and 22₁₄ may be active, e.g., providing for an aggregated sound pressure of a superposition of the same or different spectra associated with the respective valve structure.

During time instance t₃, valve structures 22₉ to 22₁₅ provide for a superposition of, in total, six contributions, whilst during time instance t₄, valve structures 22₁₁ and 22₁₂ may be active. According to an embodiment, a MEMS structure may comprise a two-dimensional array in which, for example, one of a line or column provides for valve structures of different spectra and the respective other dimension provides for valve structures of a same spectrum to allow an increase of sound pressure to be generated. This may allow to control the spectra (volume) components and/or the amplitude of audible sound to be obtained with the MEMS device.

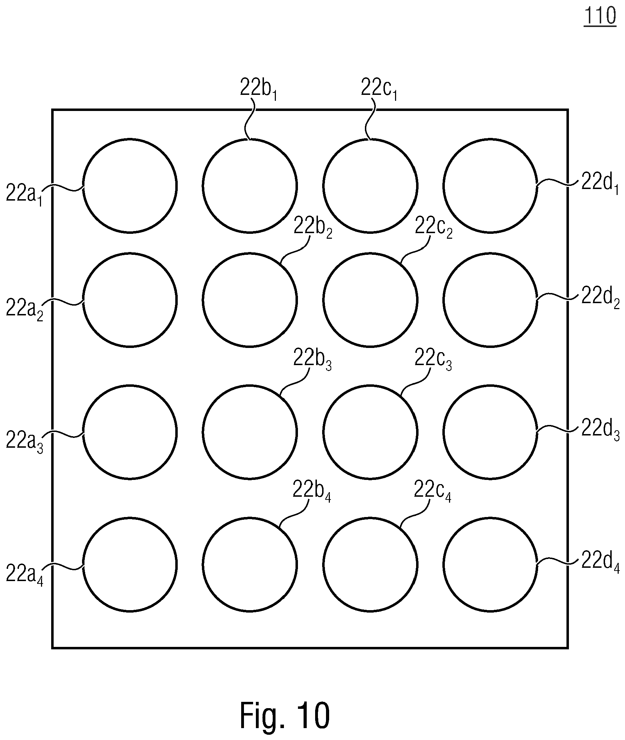

Fig. 10 shows a schematic top view of a part of a MEMS device 110 according to an embodiment, wherein the details provided may be applied, without limitation, to other MEMS devices described herein. In acoustic communication with a single membrane structure 14, an arrangement of valve structures 22a₁ to 22d₄ may be arranged in four lines and four columns. This does not exclude to have a second, further membrane structure in acoustic communication with additional valve structures and/or to have a different number of valve structures, a different number of lines and/or a different number of columns of valve structures in communication with the membrane structure 14. For example, valve structures 22a₁ to 22a₄ may be formed so as to comprise a same resonance frequency, e.g., based on spring structures. Valve elements 22b₁ to 22b₄ may comprise a different second resonance frequency whilst valve structures 22c₁ to 22c₄ and 22d₁ to 22d₄ may comprise a third and fourth resonance frequency. Based on a suitable control signal, this may allow to contribute with different spectra to the audible signal, e.g., for the ultrasonic demodulation or suppression being implemented in the MEMS device. A use of one, two, three or four of the respective valve structure 22a, 22b, 22c or 22d may allow to increase or reduce a sound pressure contribution of said frequency, whilst a deactivation of all of the respective valve structures having a resonance frequency may lead to an absence of said spectrum. As described, such a MEMS device may be configured for a use with an ultrasonic demodulation concept, e.g., to individually operate different valve structures in communication with a same membrane with different operation frequencies.

Such a structure may allow for a detailed controlled of the generated output. For example, the membrane may be operated at a resonance frequency thereof and valve structures may be operated at a resonance frequency thereof. A vibration or movement of the shutter structure of different rows may be operated in resonance each and with a phase shift of 90° with regard to one another to emulate the analogue sound. An amplitude of the sound may be adapted via a parallel path having a further shutter structure.

A use of an individual mechanical resonance may be a part of one solution of generating a movement of the shutter structures of the corresponding valve structures 22a-22d with different frequencies. Alternatively or in addition to individual mechanical resonance frequencies that may be used for a respective resonant operation, for operating different valve structures at different frequencies, a non-resonant operation may be implemented in MEMS devices described herein. For example, a non-resonant operation mode may comprise a control to obtain snapping, an electro-mechanical pull-in or the like.

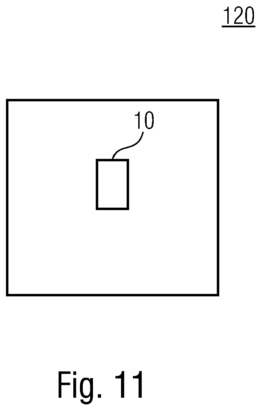

Fig. 11 shows a schematic block diagram of an apparatus 120 according to an embodiment. Apparatus 120 may comprise MEMS device 10 and/or a different MEMS device described herein and may implement, for example, a loudspeaker, e.g., as a part of an earphone.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present disclosure. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. MEMS device (10, 20, 40, 50, 60, 80, 110) comprising:
a substrate (12) comprising a cavity (18);
a membrane structure (14) mechanically connected to the substrate and configured for deflecting out-of-plane with regard to a substrate plane and with a frequency in an ultrasonic frequency range to cause a motion of a fluid (16) in the cavity
a valve structure (22) sandwiching the cavity together with the membrane structure
wherein the valve structure comprises a planar perforated structure (24);
wherein the valve structure comprises a shutter structure (26) opposing the perforated structure and arranged moveably in-plane with regard to the substrate plane and with a frequency in the ultrasonic frequency range and between a first position and a second position;
wherein the shutter structure is arranged to provide a first fluidic resistance for the fluid in the first position and a second, higher fluidic resistance for the fluid in the second position; and
further comprising a control circuitry (42) configured for controlling a deflection of the membrane structure to deflect with a first ultrasonic frequency; and for controlling an actuator structure (44) coupled to the shutter structure to change between the first position and the second position with a same or different second ultrasonic frequency to generate a sound pressure level in a front volume (38) of the MEMS device in an audio frequency range from the first ultrasonic frequency;
**characterized in that** the control circuitry is configured for controlling the actuator structure to move the shutter structure into one of the first position and the second position at an instance of time based on a deflection state of the membrane structure at the instance of time.

2. The MEMS device of claim 1, wherein the membrane structure is arranged at a first side of the valve structure; wherein the front volume of the MEMS device is arranged at an opposing second side of the valve structure; wherein the control circuitry is configured for controlling the actuator structure and the membrane structure for aggregating a fluidic pressure of the fluid motion generated by the membrane structure in the front volume by use of the valve structure.

3. The MEMS device of one of claims 1 or 2, comprising a plurality of valve structures (22₁ - 22₄) sandwiching the cavity together with the membrane structure, wherein the control circuitry is configured for controlling the membrane structure and for individually controlling the plurality of valve structures of the MEMS device, for providing different spectra of the fluidic motion from the cavity with the plurality of valve structures.

4. The MEMS device according to one of the previous claims, comprising a spring structure (104₁ - 104₄) elastically hinging the shutter structure in a rest position; and comprising an actuator structure configured for deflecting the shutter structure in-plane along a direction of movement and out of the rest position.

5. The MEMS device of claim 4, wherein the shutter structure and the spring structure form at least a part of a resonator having a resonance frequency in the ultrasonic frequency range.

6. The MEMS device of claim 4 or 5, wherein the spring structure comprises an out-of-plane mechanical stiffness being larger when compared to an in-plane mechanical stiffness along the direction of movement.

7. The MEMS device of one of the previous claims, wherein the membrane structure comprises a plurality of ventilation holes (46) configured for a passage of the fluid into the cavity whilst preventing an acoustic short circuit.

8. The MEMS device of one of the previous claims, comprising a sealing structure (54₁, 54₂) between the perforated structure and the shutter structure, wherein, in a closed state of the valve structure the sealing structure is configured for obstructing a fluid flow through a gap (56₁) between the perforated structure and the shutter structure

9. The MEMS device according to one of the previous claims, comprising anti-stiction bumps (52₁, 52₂) between the perforated structure and the shutter structure and comprising a sealing structure (54₁, 54₂) between the perforated structure and the shutter structure, wherein a remaining gap (56₂) in an area of the sealing structure is larger when compared to a gap (56₁) in an area of the anti-stiction bumps.

10. The MEMS device of one of the previous claims, wherein the perforated structure comprises a mechanical stiffening (64₁, 64₂), the mechanical stiffening configured for suppressing an out-of-plane deflection of the perforated structure; and/or wherein the shutter structure comprises a mechanical stiffening, the mechanical stiffening configured for suppressing an out-of-plane deflection of the shutter structure.

11. The MEMS device of one of the previous claims, wherein the cavity is one of a plurality of cavities being adjacently arranged; wherein each of the plurality of cavities is sandwiched between the membrane structure and a dedicated valve structure according to any of the previous claims.

12. The MEMS device of one of the previous claims, wherein the shutter structure comprises a lattice structure comprising at least one bar that, when being projected into a common plane parallel to the substrate plane, overlaps with an opening of a perforation of the perforated structure in the second position and reveals at least a part of the opening in the first position when being projected into the common plane.

13. The MEMS device of one of the previous claims, comprising a protective structure (72) transparent for a sound pressure level of the fluid and arranged to sandwich the valve structure together with the membrane structure, the protective structure configured for mechanically protecting the valve structure.

14. An apparatus (120) comprising a MEMS device of one of the previous claims and being a loudspeaker.

## Patentansprüche

1. MEMS-Vorrichtung (10, 20, 40, 50, 60, 80, 110), die Folgendes umfasst:
ein Substrat (12), das einen Hohlraum (18) umfasst;
eine Membranstruktur (14), die mechanisch mit dem Substrat verbunden ist und dafür ausgelegt ist, in Bezug auf eine Substratebene aus der Ebene heraus ausgelenkt zu werden und mit einer Frequenz in einem Ultraschallfrequenzbereich, um eine Bewegung eines Fluids (16) in dem Hohlraum zu bewirken;
eine Ventilstruktur (22), die den Hohlraum zusammen mit der Membranstruktur sandwichartig einschließt;
wobei die Ventilstruktur eine planare perforierte Struktur (24) umfasst;
wobei die Ventilstruktur eine Verschlussstruktur (26) umfasst, die der perforierten Struktur gegenüberliegt und in Bezug auf die Substratebene in der Ebene und mit einer Frequenz im Ultraschallfrequenzbereich und zwischen einer ersten Stellung und einer zweiten Stellung beweglich angeordnet ist;
wobei die Verschlussstruktur dahingehend angeordnet ist, in der ersten Stellung einen ersten Fluidwiderstand für das Fluid und in der zweiten Stellung einen zweiten, höheren Fluidwiderstand für das Fluid bereitzustellen; und
ferner umfassend eine Steuerschaltungsanordnung (42), die dafür ausgelegt ist, eine Auslenkung der Membranstruktur so zu steuern, dass sie mit einer ersten Ultraschallfrequenz ausgelenkt wird; und eine Aktuatorstruktur (44), die mit der Verschlussstruktur gekoppelt ist, so zu steuern, dass sie zwischen der ersten Stellung und der zweiten Stellung mit einer gleichen oder anderen zweiten Ultraschallfrequenz wechselt, um anhand der ersten Ultraschallfrequenz einen Schalldruckpegel in einem vorderen Volumen (38) der MEMS-Vorrichtung in einem Audiofrequenzbereich zu erzeugen;
**dadurch gekennzeichnet, dass** die Steuerschaltungsanordnung dafür ausgelegt ist, die Aktuatorstruktur so zu steuern, dass sie die Verschlussstruktur zu einem Zeitpunkt basierend auf einem Auslenkungszustand der Membranstruktur zu dem Zeitpunkt in entweder die erste Stellung oder die zweite Stellung bewegt.

2. MEMS-Vorrichtung nach Anspruch 1, wobei die Membranstruktur an einer ersten Seite der Ventilstruktur angeordnet ist; wobei das vordere Volumen der MEMS-Vorrichtung an einer gegenüberliegenden zweiten Seite der Ventilstruktur angeordnet ist; wobei die Steuerschaltungsanordnung zum Steuern der Aktuatorstruktur und der Membranstruktur zum Akkumulieren eines Fluiddrucks der durch die Membranstruktur erzeugten Fluidbewegung in dem vorderen Volumen unter Verwendung der Ventilstruktur ausgelegt ist.

3. MEMS-Vorrichtung nach einem der Ansprüche 1 oder 2, die eine Mehrzahl von Ventilstrukturen (22₁ - 22₄) umfasst, die den Hohlraum zusammen mit der Membranstruktur sandwichartig einschließen, wobei die Steuerschaltungsanordnung zum Steuern der Membranstruktur und zum individuellen Steuern der Mehrzahl von Ventilstrukturen der MEMS-Vorrichtung ausgelegt ist, um unterschiedliche Spektren der Fluidbewegung aus dem Hohlraum mit der Mehrzahl von Ventilstrukturen bereitzustellen.

4. MEMS-Vorrichtung nach einem der vorhergehenden Ansprüche, die eine Federstruktur (104₁ - 104₄) umfasst, die die Verschlussstruktur in einer Ruhestellung elastisch lagert; und die eine Aktuatorstruktur umfasst, die zum Auslenken der Verschlussstruktur in der Ebene entlang einer Bewegungsrichtung und aus der Ruhestellung heraus ausgelegt ist.

5. MEMS-Vorrichtung nach Anspruch 4, wobei die Verschlussstruktur und die Federstruktur mindestens einen Teil eines Resonators mit einer Resonanzfrequenz im Ultraschallfrequenzbereich bilden.

6. MEMS-Vorrichtung nach Anspruch 4 oder 5, wobei die Federstruktur eine mechanische Steifigkeit aus der Ebene heraus umfasst, die im Vergleich zu einer mechanischen Steifigkeit in der Ebene entlang der Bewegungsrichtung größer ist.

7. MEMS-Vorrichtung nach einem der vorhergehenden Ansprüche, wobei die Membranstruktur eine Mehrzahl von Belüftungslöchern (46) umfasst, die für einen Durchgang des Fluids in den Hohlraum ausgelegt sind, während ein akustischer Kurzschluss verhindert wird.

8. MEMS-Vorrichtung nach einem der vorhergehenden Ansprüche, die eine Dichtungsstruktur (54₁, 54₂) zwischen der perforierten Struktur und der Verschlussstruktur umfasst, wobei die Dichtungsstruktur in einem geschlossenen Zustand der Ventilstruktur dafür ausgelegt ist, einen Fluidstrom durch einen Spalt (56₁) zwischen der perforierten Struktur und der Verschlussstruktur zu behindern.

9. MEMS-Vorrichtung nach einem der vorhergehenden Ansprüche, die Anti-Stiction-Höcker (52₁, 52₂) zwischen der perforierten Struktur und der Verschlussstruktur umfasst, und die eine Dichtungsstruktur (54₁, 54₂) zwischen der perforierten Struktur und der Verschlussstruktur umfasst, wobei ein verbleibender Spalt (56₂) in einem Bereich der Dichtungsstruktur im Vergleich zu einem Spalt (56₁) in einem Bereich der Anti-Stiction-Höcker größer ist.

10. MEMS-Vorrichtung nach einem der vorhergehenden Ansprüche, wobei die perforierte Struktur eine mechanische Versteifung (64₁, 64₂) umfasst, wobei die mechanische Versteifung zum Unterdrücken einer Auslenkung der perforierten Struktur aus der Ebene heraus ausgelegt ist; und/oder
wobei die Verschlussstruktur eine mechanische Versteifung umfasst, wobei die mechanische Versteifung zum Unterdrücken einer Auslenkung der Verschlussstruktur aus der Ebene heraus ausgelegt ist.

11. MEMS-Vorrichtung nach einem der vorhergehenden Ansprüche, wobei der Hohlraum einer von einer Mehrzahl von Hohlräumen ist, die benachbart angeordnet sind; wobei jeder der Mehrzahl von Hohlräumen zwischen der Membranstruktur und einer dedizierten Ventilstruktur nach einem der vorhergehenden Ansprüche sandwichartig angeordnet ist.

12. MEMS-Vorrichtung nach einem der vorhergehenden Ansprüche, wobei die Verschlussstruktur eine Gitterstruktur umfasst, die mindestens einen Stab umfasst, der, wenn er in eine gemeinsame Ebene parallel zu der Substratebene projiziert wird, in der zweiten Stellung mit einer Öffnung einer Perforation der perforierten Struktur überlappt und in der ersten Stellung mindestens einen Teil der Öffnung freilegt, wenn er in die gemeinsame Ebene projiziert wird.

13. MEMS-Vorrichtung nach einem der vorhergehenden Ansprüche, die eine Schutzstruktur (72) umfasst, die für einen Schalldruckpegel des Fluids durchlässig ist und dahingehend angeordnet ist, die Ventilstruktur zusammen mit der Membranstruktur sandwichartig einzuschließen, wobei die Schutzstruktur zum mechanischen Schützen der Ventilstruktur ausgelegt ist.

14. Einrichtung (120), die eine MEMS-Vorrichtung nach einem der vorhergehenden Ansprüche umfasst und bei der es sich um einen Lautsprecher handelt.

## Revendications

1. Dispositif MEMS (10, 20, 40, 50, 60, 80, 110) comprenant un substrat (12) comprenant une cavité (18) ;
une structure (14) à membrane assemblée mécaniquement au substrat et configurée pour être défléchie hors du plan par rapport à un plan du substrat à une fréquence dans une plage de fréquences ultrasonores pour provoquer un mouvement d'un fluide (16) dans la cavité ;
une structure (22) de soupape prenant en sandwich la cavité ensemble avec la structure à membrane ;
dans lequel la structure de soupape comprend une structure (24) plane perforée ;
dans lequel la structure de soupape comprend une structure (26) d'obturateur en opposition à la structure perforée et agencée de manière mobile dans le plan par rapport au plan du substrat, à une fréquence dans la plage de fréquences ultrasonores, entre une première position et une deuxième position ;
dans lequel la structure d'obturateur est agencée pour fournir une première résistance fluidique pour le fluide dans la première position et une deuxième résistance fluidique plus grande pour le fluide dans la deuxième position ; et
comprenant en outre un circuit (42) de commande configuré pour commander une déflexion de la structure à membrane de sorte qu'elle soit défléchie à une première fréquence ultrasonore ; et pour commander une structure (44) d'actionneur accouplée à la structure d'obturateur pour passer entre la première position et la deuxième position à .
une même deuxième fréquence ultrasonore ou à une deuxième fréquence ultrasonore différente, afin de créer un niveau de pression acoustique dans un volume (38) avant du dispositif MEMS dans une plage de fréquences audio à partir de la première fréquence ultrasonore ;
**caractérisé en ce que** le circuit de commande est configuré pour commander la structure d'actionneur afin de déplacer la structure d'obturateur dans l'une de la première position et de la deuxième position à un instant donné sur la base d'un état de déflexion de la structure à membrane à l'instant donné.

2. Le dispositif MEMS de la revendication 1, dans lequel la structure à membrane est disposée d'un premier côté de la structure de soupape ; dans lequel le volume avant du dispositif MEMS est disposé d'un deuxième côté opposé de la structure de soupape ; dans lequel le circuit de commande est configuré pour commander la structure d'actionneur et la structure à membrane pour agréger une pression fluidique du mouvement de fluide généré par la structure à membrane dans le volume avant par l'utilisation de la structure de soupape.

3. Le dispositif MEMS de l'une des revendications 1 ou 2, comprenant une pluralité de structures (22₁ - 22₄) de soupape prenant en sandwich la cavité ensemble avec la structure à membrane, dans lequel le circuit de commande est configuré pour commander la structure à membrane et pour commander individuellement la pluralité de structures de soupape du dispositif MEMS, afin de fournir différents spectres du mouvement fluidique à partir de la cavité par la pluralité de structures de soupape.

4. Le dispositif MEMS selon l'une des revendications précédentes, comprenant une structure (104₁ - 104₄) à ressort suspendant élastiquement la structure d'obturateur dans une position de repos ; et comprenant une structure d'actionneur configurée pour défléchir la structure d'obturateur dans le plan suivant une direction de déplacement et hors de la position de repos.

5. Le dispositif MEMS de la revendication 4, dans lequel la structure d'obturateur et la structure à ressort forment au moins une partie d'un résonateur ayant une fréquence de résonance dans la plage de fréquences ultrasonores.

6. Le dispositif MEMS de la revendication 4 ou 5, dans lequel la structure à ressort comprend une rigidité mécanique hors du plan plus grande qu'une rigidité mécanique dans le plan suivant la direction de déplacement.

7. Le dispositif MEMS selon l'une des revendications précédentes, dans lequel la structure à membrane comprend une pluralité de trous (46) de ventilation configurés pour un passage du fluide dans la cavité tout en empêchant un court-circuit acoustique.

8. Le dispositif MEMS selon l'une des revendications précédentes, comprenant une structure (54₁, 54₂) d'étanchéité entre la structure perforée et la structure d'obturateur, dans lequel, dans l'état fermé de la structure de soupape, la structure d'étanchéité est configurée pour faire obstacle à un écoulement de fluide dans un interstice (56₁) entre la structure perforée et la structure d'obturateur.

9. Le dispositif MEMS selon l'une des revendications précédentes, comprenant des bosses (52₁, 52₂) anti-adhérence entre la structure perforée et la structure d'obturateur et comprenant une structure (54₁, 54₂) d'étanchéité entre la structure perforée et la structure d'obturateur, dans lequel un interstice (56₂) restant dans une zone de la structure d'étanchéité est plus grand qu'un interstice (56₁) dans une zone des bosses anti-adhérence.

10. Le dispositif MEMS selon l'une des revendications précédentes, dans lequel la structure perforée comprend un raidissement mécanique (64₁, 64₂), le raidissement mécanique étant configuré pour supprimer une déflexion hors du plan de la structure perforée ; et/ou
dans lequel la structure d'obturateur comprend un raidissement mécanique, le raidissement mécanique étant configuré pour supprimer une déflexion hors du plan de la structure d'obturateur.

11. Le dispositif MEMS selon l'une des revendications précédentes, dans lequel la cavité est l'une d'une pluralité de cavités disposées de manière adjacente ; dans lequel chacune des cavités de la pluralité est prise en sandwich entre la structure à membrane et une structure de soupape dédiée selon l'une des revendications précédentes.

12. Le dispositif MEMS selon l'une des revendications précédentes, dans lequel la structure d'obturateur comprend une structure à treillis comprenant au moins une barre qui, lorsqu'elle est projetée dans un plan commun parallèle au plan du substrat, chevauche une ouverture d'une perforation de la structure perforée dans la deuxième position et laisse apparaître au moins une partie de l'ouverture dans la . première position lorsqu'elle est projetée dans le plan commun.

13. Le dispositif MEMS selon l'une des revendications précédentes, comprenant une structure de protection (72) transparente pour un niveau de pression acoustique du fluide et agencée pour prendre en sandwich la structure de soupape ensemble avec la structure à membrane, la structure de protection étant configurée pour protéger mécaniquement la structure de soupape.

14. Un appareil (120) comprenant un dispositif MEMS suivant l'une des revendications précédentes et étant un haut-parleur.
